# EUROPEAN PATENT APPLICATION

(11) **EP 2 789 569 A2**
(43) Date of publication of application: **15.10.2014**
(21) Application number: 14160799.4
(22) Date of filing: 20.03.2014
(51) Int. Cl.: B66F 9/00, H05K 7/14

(54) **Installation arrangement for a power electronics device**

(30) Priority: 11.04.2013 FI 20134089 U
(71) Applicant: Vacon Oyj, 65380 Vaasa (FI)
(72) Inventor: Stasiunas, Dainius, 37118 Panevezys (LT)
(74) Representative: Nervola, Jussi Tapani

(57) **Abstract**

Arrangement for moving a structural unit (115) belonging to a power electronics device or forming a power electronics device into or out of an electrical installation enclosure (111, 112) to be installed at floor level, which arrangement comprises an electrical installation enclosure (111, 112). The electrical installation enclosure (111, 112) comprises a support disposed above floor level and the arrangement further comprises a support ramp (126), which can be situated between the floor (125) and the support disposed above floor level, wherein the support ramp (126) disposed between the floor (125) and the support disposed above floor level forms a sloping ramp.

## Description

### Field of technology

The object of the present invention is an arrangement for installing a structural unit belonging to a power electronics device or forming a power electronics device into an electrical installation enclosure.

### Prior art

High-powered power electronics devices, such as frequency converters or their separate structural units, are normally installed into electrical installation enclosures that function as, *inter alia,* a protection against contact guaranteeing the electrical safety of the user. To facilitate the installation or replacement of devices in, *inter alia,* a servicing situation, the enclosures generally comprise for these prefabricated mechanical supporting structures and electrical connections to other submodules and to external connectors.

In the bottom part of installation enclosures there can be a so-called plinth space in which, inter alia, electric cables are disposed. A plinth can be e.g. 10cm high, and the aforementioned electrical devices are installed above it. Lifting high-powered structural units, which can weigh up to many hundreds of kilograms, to this height can be problematic, particularly in a servicing situation in which the space available in front of the installation enclosure can be cramped. A corresponding hindrance to installation can also be a support bar, situated at floor level, belonging to the enclosure structure, which bar forms a step in the passage leading inside the enclosure.

A known solution for getting a heavy structural unit to installation height is collaborative lifting by a number of people. In cramped spaces, however, generally at most 2 people can simultaneously grip the device, so that this method is sufficient for up to perhaps approx. 100 kg. For lifting heavier devices a crane is needed. For a servicing situation both arrangements - getting a number of people to the site, and transporting a crane to the installation spaces - are problematic. One problem is also the long period of servicing work required by conventional methods, during which period the process in which the device being serviced is used generally has to be stopped.

### Summary of the invention

The aim of the present invention is to solve the aforementioned problem and to provide a novel arrangement that facilitates the installation work of a heavy power electronics device, especially in on-site conditions. The aim is achieved with the arrangement according to the invention, which is characterized by what is stated in the characterization part of the independent claim. Other preferred embodiments of the invention are the objects of the dependent claims.

In the invention a sloping support ramp is utilized, along which a heavy structural unit of a power electronics device is moved into position in an enclosure or moved out of it. When installing, a structural unit can slide along the support ramp or it can be provided with wheels for making the moving easier.

The support ramp can be detachable, and it can be used only during installation work. According to a preferred embodiment of the invention some part belonging to the enclosure structure is used as a support ramp, which part is partly or wholly detached from its original position for the duration of a servicing situation. This type of part can be e.g. a protection against contact plate installable in front of the bare connections of a device or a detachable bottom part of the front door of the installation enclosure, which bottom part can be a perforated part of the ventilation system of the enclosure. The support ramp can, of course, also be a separate part that does not belong to the enclosure structure.

According to a preferred embodiment of the invention a structural unit is lowered down along the support ramp, or lifted upwards along it towards an enclosure, by the aid of an elongated screw, in which case very little use of manual force is needed.

The invention makes it possible for only one fitter to replace a heavy structural unit in on-site conditions, and with very little use of force. The time needed for the replacement work is short when compared to prior art.

### Brief description of the figures

In the following, the invention will be described in more detail by the aid of some examples of its embodiments with reference to the attached drawings, wherein
Fig. 1 presents a row of installation enclosures and the placement of a power electronics device inside the installation enclosures,
Fig. 2 presents an installation enclosure,
Fig. 3 presents an arrangement according to prior art for lifting a heavy structural unit inside an installation enclosure,
Fig. 4 presents an arrangement according to prior art for moving a heavy structural unit into or out of an installation enclosure, and
Fig. 5 presents a support ramp solution according to the invention.

### Detailed description of the invention

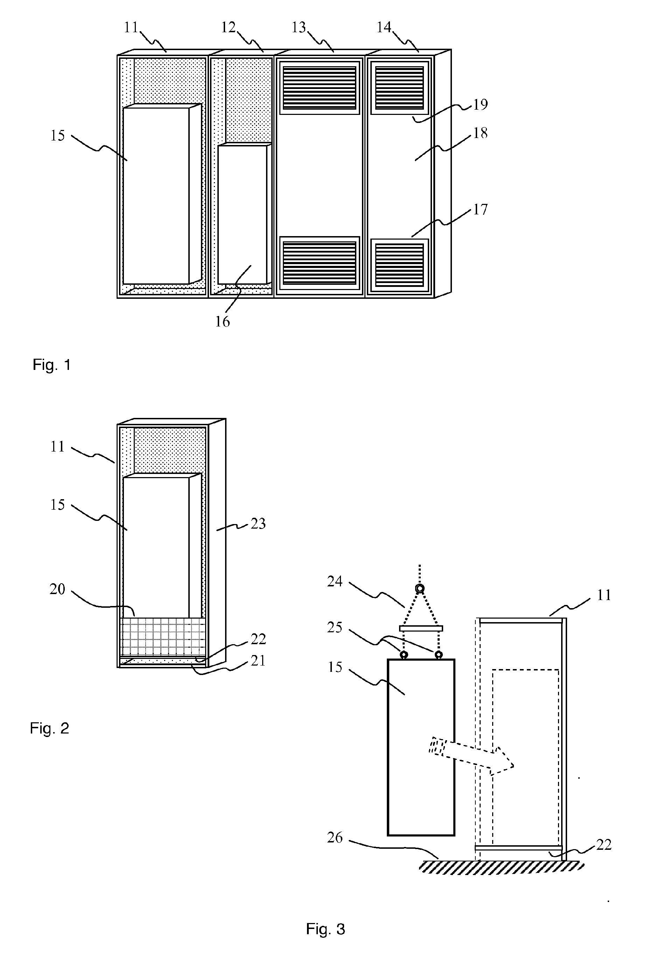

Fig. 1 presents a typical row of installation enclosures of a power electronics device, e.g. of a frequency converter, and the placement of its various structural units inside the enclosures. In order to highlight the essential features describing the invention, this figure, as well as the other figures in this document, have been presented in a simplified form without e.g. the fixing arrangements for devices, which are obvious to a person skilled in the art.

The height dimensions and depth dimensions of installation enclosures 11 - 14 disposed in the same row are normally same, e.g. height 2000 mm and depth 600 mm, respectively, and the width dimension varies according to the need of the structural unit disposed inside the enclosure. In the example of the figure, a large-sized structural unit 15 is installed inside the wide (e.g. 800 mm) enclosure 11, and a structural unit 16 of smaller size inside the narrow (e.g. 600 mm) enclosure 12. The enclosures 11 and 12 are described without front doors, the enclosures 13 and 14 correspondingly with front doors. The forced air ventilation, possibly required by the device inside an installation enclosure, is normally accomplished via the perforated front panels 17, 19 disposed in the front doors 18.

Fig. 2 presents in more detail the placement of a structural unit 15 inside an enclosure 11. An installation enclosure is generally of rectangular prism shape, the edges functioning as the frame of which prism are assembled from straight metal frame bars, an example of one of which is the front bar 21 presented in the figure. Walls that are generally fabricated from thin metal sheets, such as the side wall 23 according to the figure, and that protect the inside spaces of the enclosure are fixed to these frame bars. A base plate 22, e.g. according to the figure, for supporting the device disposed inside the enclosure can be fixed to the frame bars. The connections of power electronics devices to an external circuit are normally situated in the bottom part of the device, owing to which a perforated plate-shaped part 20 according to the figure is often disposed in front of the bottom part of a device, which plate-shaped part functions as a protection against contact and protects the user from inadvertently touching electrically live parts also when the enclosure door is open.

Fig. 3 presents a method according to prior art, with which a heavy device is lifted inside an installation enclosure. In the arrangement a crane (not presented) raises, by the aid of a rope arrangement 24 and lifting lugs 25 fixed to the device, the structural unit 15 into the air, in which case it can be pushed inside the enclosure 11, in the direction of the arrow drawn with a dashed line in the figure, onto the base plate 22 into its final position marked with a dashed line. According to the embodiment of the figure, there normally remains a space between the base plate 22 and the floor 26, in which space e.g. cables can be disposed.

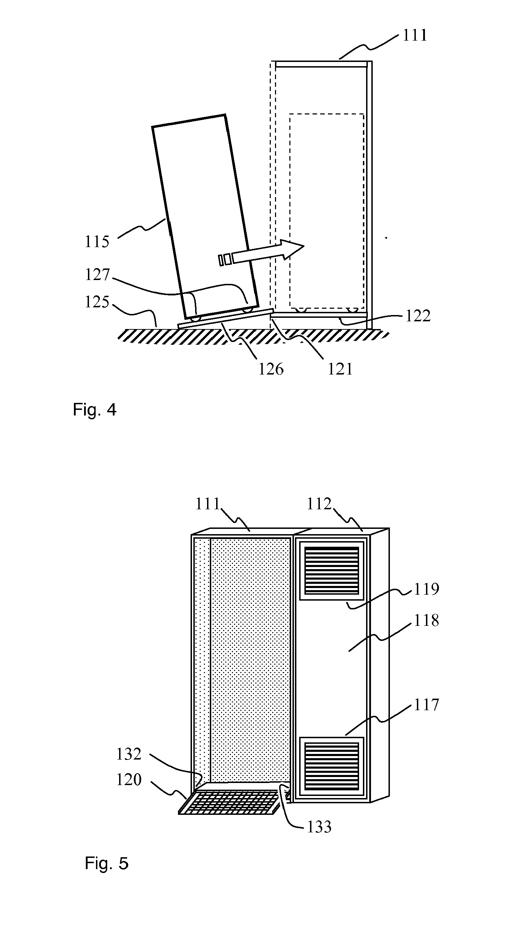

Fig. 4 presents an arrangement according to the present invention for moving a heavy device into or out of an enclosure. A sloping support ramp 126 is used in the arrangement, on top of which ramp the transfer of the structural unit 115 takes place. The support ramp is placed between the floor 125 and a support point that belongs to the installation enclosure and is situated above the floor level, such as the base plate 122, the support bar (Fig. 2, part 21) of the front part 121 of the base plate, said bar functioning as a step, or a corresponding support point. In order to facilitate the move, the bottom part of the device can have small wheels 127, or e.g. roller bearings with the outer rims rolling against the metal edge of the support ramp can be used as such. The moving can, of course, take place also by sliding, without wheels.

The support ramp according to the invention can be a separate part that the servicing personnel bring with them. According to a preferred embodiment of the invention a part of the enclosure structure is used as a support ramp, which part is partly or wholly detached from its original position. Fig. 5 presents two installation enclosures 111, 112, the forced air ventilation possibly needed by the devices disposed inside which enclosures can be accomplished via the perforated front panels 117, 119 disposed in the front doors 118.

In the embodiment of Fig. 5, the protection against contact plate 120 is used as a support ramp, the top end of which plate is detached from its fastenings and after that is turned against the floor while the fasteners 132, 133 of the bottom end remain in their position. The arrangement is useful in that a separate part, and therefore one easily lost accidentally, is not needed, but instead a support ramp is always available in a servicing situation.

It is obvious to the person skilled in the art that the different embodiments of the invention are not limited solely to the example described above, but that they may be varied within the scope of the claims presented below.

The characteristic features possibly presented in the description in conjunction with other characteristic features can if necessary be used separately to each other.

## Claims

1. Arrangement for moving a structural unit (115) belonging to a power electronics device or forming a power electronics device into or out of an electrical installation enclosure (111, 112) to be installed at floor level, which arrangement comprises an electrical installation enclosure (111, 112),
**characterized in that**
the electrical installation enclosure (111, 112) comprises a support disposed above floor level and
the arrangement further comprises a support ramp (126), which can be situated between the floor (125) and the support disposed above floor level, wherein the support ramp (126) disposed between the floor (125) and the support disposed above floor level forms a sloping ramp.

2. Arrangement according to claim 1, wherein the support is a base plate or support platform (122) a support bar (121) functioning as a step, or some other support bar.

3. Arrangement according to claim 1 or 2, further comprising an elongated screw and the structural unit is configured to be lowered down along the support ramp, or to be lifted upwards along it towards an electrical installation enclosure, by the aid of the elongated screw.

4. Arrangement according to any of the preceding claims, wherein the support ramp (126) is a part of the enclosure structure, such as a protection against contact (120) or air-conditioning grating (117, 119), and which support ramp (126) is arranged to be partly or wholly displaced from its original position to between the floor (125) and a support point situated above floor level.

5. Arrangement according to any of the preceding claims, wherein the top end of the support ramp is configured to be detached from its first fasteners and after that to turn against the floor while the second fasteners of the bottom end remain in their position.

6. Arrangement according to any of claims 1 - 3, wherein the support ramp is a separate part that does not belong to the enclosure structure.

7. Arrangement according to any of the preceding claims, wherein the arrangement comprises a movable structural unit (115), onto the base part of which wheels (127) have been arranged for facilitating the moving.
